# NEW EUROPEAN PATENT SPECIFICATION

(11) **EP 1 850 142 B2**
(45) Date of publication and mention of the opposition decision: **06.03.2019**
(45) Mention of the grant of the patent: 14.01.2009
(21) Application number: 06405173.3
(22) Date of filing: 24.04.2006
(51) Int. Cl.: H04L 12/26, G01R 31/327

(54) **System level testing for substation automation systems**
Test auf Systemebene für Automatisierungsysteme einer Unterstation
Test au niveau du système pour des systèmes d'automatisation d'une sous-station

(43) Date of publication of application: 31.10.2007
(73) Proprietor: ABB Research Ltd., 8050 Zürich (CH)
(72) Inventor: Kirrmann, Hubert, 5405 Dättwil (CH); Vetter, Claus, 5033 Buchs (CH); Obrist, Michael, 5400 Baden (CH); Maeda, Tetsuji, 6300 Zug (CH)
(74) Representative: ABB Patent Attorneys

(56) References cited:
- EP-A- 0 780 951
- WO-A-00/77669
- US-A- 5 963 734
- US-B1- 6 671 635
- CRISPINO F ET AL: "An experiment using an object-oriented standard-IEC 61850 to integrate IEDs systems in substations" TRANSMISSION AND DISTRIBUTION CONFERENCE AND EXPOSITION: LATIN AMERICA, 2004 IEEE/PES SAO PAULO, BRAZIL 8-11 NOV. 2004, PISCATAWAY, NJ, USA,IEEE, US, 8 November 2004 (2004-11-08), pages 22-27, XP010799829 ISBN: 0-7803-8775-9
- INTERNATIONAL STANDARD IEC61850, "COMMUNICATION NETWORKS AND SYSTEMS IN SUBSTATIONS", TEIL 10, "CONFORMANCE TESTING"; FIRST EDITION 2005-05

## Description

### FIELD OF THE INVENTION

The invention relates to the field of Substation Automation (SA) systems for substations in high and medium voltage power networks. More particularly, it relates to the testing of system level functions involving two Intelligent Electronic Devices (IEDs) of the SA system.

### BACKGROUND OF THE INVENTION

An electric power system comprises a power transmission and/or distribution network interconnecting geographically separated regions, and a plurality of substations at the nodes of the power network. The substations include equipment for transforming voltages and for switching connections between individual lines of the power network. Power generation and load flow to consumers is managed by a central Energy Management System (EMS) and/or supervised by a Supervisory Control And Data Acquisition (SCADA) system located at a Network Control Centre (NCC).

Substations in high and medium voltage power networks include primary devices such as electrical cables, lines, bus bars, switches (breakers or disconnectors), power transformers and instrument transformers which are generally arranged in switch yards and/or bays. These primary devices are operated in an automated way via a Substation Automation (SA) system responsible for controlling, protecting, measuring and monitoring of substations. The SA system comprises secondary devices, so-called digital relays, interconnected in a SA communication network, and interacting with the primary devices via a process interface. These devices are generally assigned to one of three hierarchical levels, which are (a) the station level including an Operator Work Station (OWS) with a Human-Machine Interface (HMI) as well as the gateway to the Network Control Centre (NCC), (b) the bay level with its devices for protection, control and measurement, and (c) the process level comprising e.g. electronic sensors for voltage, current and gas density measurements as well as contact probes for sensing switch and transformer tap changer positions, as well as actuators controlling the drive of a switch or tap changer. At the process level, intelligent actuators may be integrated in the respective primary devices and connected to a bay unit via a serial link or an optical process bus. The bay units are connected to each other and to the devices on the station level via an inter-bay or station bus.

Today's SA systems require interoperability between all substation devices independently of their manufacturer. To that effect, an internationally accepted communication, standard for communication between the secondary devices of a substation has been introduced by the International Electrotechnical Committee, Geneva, under the name of IEC 61850 "communication networks and systems in substations". All IEC 61850 compliant devices connected to the SA network are called Intelligent Electronic Devices (IED).

IEC 61850 defines an abstract object model for compliant substations, and a method how to access these objects over a network. This allows the substation-specific applications such as the OWS to operate with standard objects, while the actual objects in the substation may be realized differently by the IEDs of the different manufacturers. The abstract object model according to the above standard represents the SA functionality in terms of logical nodes within logical devices that are allocated to the IEDs as the physical devices. The actual communication between IEDs is handled, for non-time critical messages, via an MMS communication stack built on OSI/TCP/IP/Ethernet, or for time critical messages, via so-called Generic Object Oriented Substation Events (GOOSE) that build directly on the Ethernet link layer of the communication stack. Very time-critical signals at the process level such as trip commands and analogue voltages or currents use a simplified variant of GOOSE known as SV (Sampled Values) that also builds directly on the Ethernet link layer.

As mentioned, one consequence of the aforementioned interoperability requirement is that IEDs from different suppliers may be combined into one SA system. As the IEDs are initially configured during an engineering phase, the corresponding dedicated engineering or SA configuration tools of the different suppliers, such as ABB's IET (Integrated Engineering Tool) or ABB's CAP (Configuration and Programming) Tool, have to be able to exchange information about the IEDs. To this effect, the complete SA system with all its primary devices, IEDs and communication links must be specified in a computer-readable way. This is enabled by the comprehensive XML-based Substation Configuration Language (SCL) that is part of the IEC 61850 standard. In short, the IEC 61850 SCL language provides for a standardized description of the primary devices, the secondary devices with their PCM functions, the communication system logical structure and the relation between IEDs and primary devices, and thus enables an automated configuration of both communication and IEDs.

The SCL language is used to describe the capabilities of a particular IED or IED type in an IED Capability Description (ICD) file that lists the application functions of a physical device, e.g. the implemented protection functionality. A Configured IED Description (CID) includes further the communication properties of the IED, e.g. its unique IP address. A Substation Configuration Description (SCD) file in SCL language describes, for a particular substation, the primary objects, the functions implemented in each IED in terms of logical nodes, and the communication connections. The SCD file thus comprises (1) a switch yard naming and topology description, (2) an IED configuration description, (3) relations between switch yard elements and IED functions, and (4) a communication network description. Accordingly, if a particular IED is used within an SA system, an object instance of the IED type is inserted into the corresponding SCD file. The SCL language then allows specifying typical or individual values for data attributes carried by the instance and related to the particular IED, e.g. values for configuration attributes and setting parameters. The connection between the power process and the SA system is described in the SCL language by allocating or attaching logical nodes to elements of the primary equipment. Typically, a switch control logical node is attached to a switching device, whereas a measurement logical node is allocated to an instrument transformer. The semantic meaning of a function within an SA system is determined by the logical node type or class in combination with the switch yard and/or bay to which it is allocated.

During a substation engineering process, the SA configuration (topology, IED configuration and communication setup) is derived from the customer requirements and stored in a project-specific SCD file. For the actual installation or commissioning, all or parts of the configuration information previously engineered needs to be transferred to the physical devices, and the IEDs themselves need to be configured properly. The different IEDs are loaded with substation-specific configuration data from the SCD file and put into operation. Furthermore, IEDs from different manufacturers might be loaded individually by their own proprietary configuration tools. Part of this process is automated but most steps still require human interaction by commissioning or test engineers. This process is error-prone. Additional sources of inconsistency between the SCD file and the actual configuration of an individual IED arise from different versions of the SCL file used, or from the fact that IEDs allow their configuration to be changed locally, i.e. on the device itself or through device-specific configuration tools.

In view of the aforementioned sources of inconsistencies as well as in order to identify and possibly eliminate a number of other potential problems and deviations from the customer specific requirements, system verification and validation for any project concerning a custom-made SA system is required. Despite the fact that testing as part of all verification and validation activities cannot guarantee the absence of any error, the goal of the supplier of the SA system is to demonstrate the correct coordinated working of all parts in the most likely and important application scenarios, as well as the expected quality or performance like throughput, availability, and timely response also under high load.

Basically, a substation PCM IED is tested for compliance with its requirement specification, which includes basic operation of the device and behaviour under load, in so-called type tests or Manufacturing Acceptance Tests. The device under test is typically being tested by applying analogue signals that simulate secondary current and voltage waveforms seen by the device under simulated power system conditions. In addition, status information related to primary equipment as well as other logic and control signals are transmitted to the device over a digital communication link or data network during the simulated power system fault. The apparatus or testing device for generating the mentioned analogue signals comprises an analogue signal generator, while digital signal generators simulate the operation of a circuit breaker or other pieces of equipment. Testing of PCM IEDs based on a data exchange using digital communication between the testing system and the IEDs under test, is disclosed in the patent application US 2002/0173927.

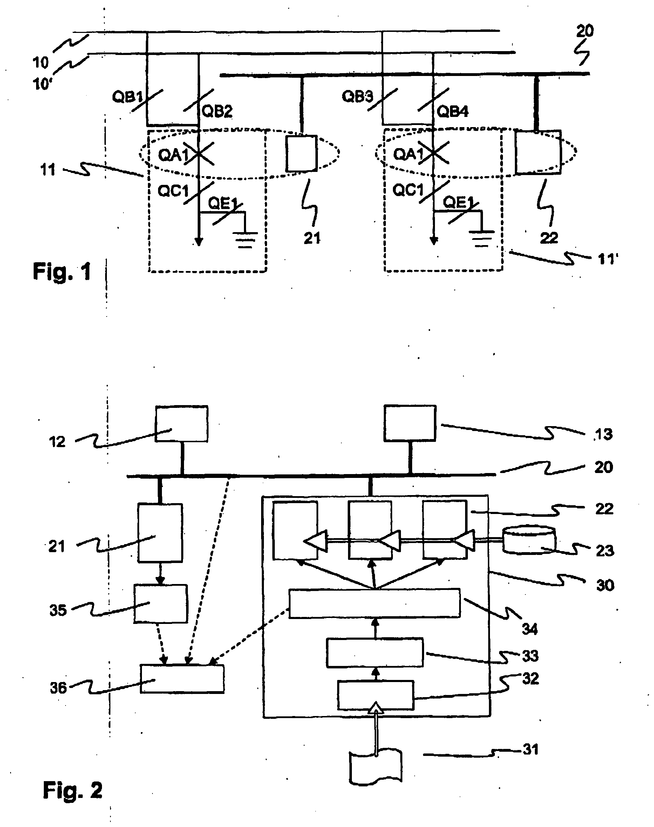

Further, IEC 61850-10, first edition, 2005-05, relates to conformance testing in the communication networks and systems in substations, wherein item 5 describes the conformance test for communication and system related test of the incorporated IEDs. In particular, Fig. 2 of on page 18 shows a conceptional test system architecture, including the setup for station bus, process bus, the device under test DUT, as well as the simulator acting as a client and server for initiating and generating messages. Further, this document describes that the test entity shall generate from the ICD file, the corresponding SC file based on the configuration of the test system.

In the EP-A-0 780 951 (EATON CORP, 25 June 1997) a remote device is used for simulating faults in a network system with a plurality a circuits breakers with computing capabilities that may be regarded as intelligent electronic devices. A central location sends emulation data of specific faults in the network.

However, the operation of a particular PCM IED depends also on signals that are generated by other PCM IEDs, e.g. for the purpose of interlocking. Therefore, in order to reproduce all expected switching states, such signals likewise have to be manipulated, and a larger range of tests allowing to influence the signals generated by other IEDs, hereafter called system level tests, have been devised. In an exemplary system level test known as Factory Acceptance Test (FAT), for a particular substation project, checks are being made to verify that the correct devices are included and, among others, that the protection functions have been properly implemented. In a further system level test known as a System Verification Test, all possible device configurations that can be supported are tested for compliance with a worst case system configuration corresponding to a hypothetical substation project of maximum extension. The aforementioned system level tests are generally performed in a test environment or test laboratory, in which a number of IEDs are installed. However, due to the sheer number of IFDs necessitating an increasingly complicated test rig, and due to cost and space limitations, not all the IEDs of a particular substation are installed for a FAT, let alone the huge number of IEDs that would be needed for the largest possible substation in a system verification test. Accordingly, the extent of the test configurations, and the complexity of the abovementioned signal patterns, is limited.

### DESCRIPTION OF THE INVENTION

It is therefore an objective of the invention to facilitate testing of system level functionality involving several Protection, Control and Measurement (PCM) Intelligent Electronic Devices (IEDs) of a Substation Automation (SA) system. This objective is achieved by a method of performing, and a test environment for, a Substation Automation (SA) system level test according to claims 1 and 6, respectively. Further preferred embodiments are evident from the dependent patent claims.

According to the invention, an extensive testing of all conceivable PCM functions or applications of an extended SA system comprising a large number of IEDs with a multitude of configurations is facilitated by simulating at least one of the IEDs in a testing device. Hence, only a limited number of IEDs are physically present as individual devices in a test environment, the behaviour of at least one further IED being simulated by a dedicated testing device with appropriate data processing means. The testing device sends network messages indicative of the behaviour of the simulated IED according to its communication and device configuration over a substation communication network such as a Local Area Network (LAN) to the physically present IED under test. The latter may be a single individual IED such as an Operator Work Station (OWS), a logging device or a communication gateway to the Network Control Centre (NCC), or it may be any one PCM device of a plurality of IEDs belonging to a particular bay of a substation to be controlled by the SA system. The proper working of the configured device functions or allocated logical nodes, i.e. the expected correct action as triggered by the testing device are then verified by analyzing the response of the device, under test over its analogue and digital outputs, as well as its response over the communication network.

The invention takes advantage of the standardized description of the implemented device functions or capabilities and the standardized Substation Configuration Description (SCD) of the substation for which the SA system comprising the IEDs is intended. Accordingly, the testing device obtains all required information about the IEDs to be simulated by parsing a corresponding SCL file, reading data objects and extracting the configuration information corresponding to each IED.

According to of the invention, a fraction of all the I EDs of an extended SA system is physically present in a test environment, and these IEDs are detected automatically by the testing device. This is done by checking the communication network and trying to connect to all the IEDs of the SA system, i.e. by browsing the communication network for IEDs configured according to the standard IEC 61850. Those IEDs that are referred to in the SCD file of the substation but that are not responding when called by the testing device are concluded to be missing from the test environment. Hence, by comparing the information from the SCL file (as being engineered) and the responses above, the IEDs which are engineered for the substation but which are not physically installed in the test environment are identified and subsequently can be simulated in the testing device for proper testing of the actual IEDs under test.

In an advantageous variant, an Operator Work Station (OWS) that comprises a human machine interface and facilities for event recording is considered a special case of an IED, and its operation is tested by means of the testing device simulating the IEDs of the SA system to Which the OWS belongs. In other words, apart from being used as a testing device for testing PCM IEDs, the OWS may itself be a device under test. By monitoring the messages generated by the OWS, event reporting as well as data and clock formats can be verified at an early stage in the engineering process, without any physical IED actually being installed for the purpose of stimulating the OWS under test.

In a further preferred embodiment of the invention, test sequences or scenarios are introduced through a script language, and the testing device or simulator is able to read script files to play scenarios in an automated way, in particular without moving switches or controlling voltage generators by hand. Scripts may be triggered in response to an external event, e.g. a command or request from an OWS or a spontaneous change within an IED. Preferably, the monitored response of the device under test is compared to an expected value according to the test scenario in order to verify the correct working of the device under test. This can be done e.g. by checking the state of the OWS through its OPC interface or by measuring process signals.

Since the processing power of the hardware that runs the simulator is limited, the test environment according to the invention may be advantageously refined, in particular for simulating a multitude of IEDs concurrently, by providing several testing devices as synchronized simulators. In addition, if the latter are connected independently to the SA communication network, e.g. via their dedicated Ethernet controllers connected to different switches in the network, heavy communication traffic in the substation can be generated in a more realistic manner. Likewise, problems due to one single Ethernet controller with limited capacity filtering nearest-neighbour traffic and/or generating non-realistic network traffic can be relieved as well.

In a further variant of the test environment, simulated process signals are applied to the analogue and/or binary inputs of the IED under test, either directly by the testing device or simulator, or generated by an additional signal generator distant from the simulator and connected to the latter. Hence, this signal generator is not required to be compliant with the standard, and can be of a conventional type.

The present invention also relates to a computer program product including computer program code means for controlling one or more processors of a testing device connected to the communication network of a Substation Automation system, and configured to execute the steps of reading a standardized description of implemented functions of an BED and sending network messages, particularly, a computer program product including a computer readable medium containing therein the computer program code means.

### BRIEF DESCRIPTION OF THE DRAWINGS

The subject matter of the invention will be explained in more detail in the following text with reference to preferred exemplary embodiments which are illustrated in the attached drawings, in which:
Fig. 1 shows an excerpt of a single line diagram of a substation,
Fig.2 schematically shows a basic test arrangement,
Fig.3 schematically shows a test arrangement with two testing devices, and
Fig.4 schematically shows a test arrangement with an additional process signal generator distant from the testing device.

The reference symbols used in the drawings, and their meanings, are listed in summary form in the list of reference symbols. In principle, identical parts are provided with the same reference in the figures.

### DETAILED DESCRIPTION OF PREFERRED EMBODIMENTS

Fig.1 shows a single line diagram of a part or section of an exemplary substation at an assumed voltage level of e.g. 110 kV, together with some communication links and SA or secondary equipment. The model of a switch yard at single line level contains the topological respectively electrical connections between primary equipment. The substation comprises a double bus bar configuration with two bus bars 10, 10', each of them feeding two bays 11, 11' via disconnectors QB1 to QB4. Each bay comprises a circuit breaker QA1, a disconnector QC1 and an earthing switch QE1. The corresponding excerpt of the substation automation system depicts, in bold lines, a communication network 20 and two IEDs 21, 22, which both host logical nodes of class CSWI (switch control). Each logical node is allocated to one of the aforementioned circuit breakers QA1 as indicated by the dash-dot lines in Fig.1.

Fig.2 shows a test environment or test set-up according to the invention as well as a first IED 21 under test. The latter is connected to the SA communication network 20, as are the Operator Work Station 12, the gateway to the Network Control Centre 13, and a testing device 30 with dedicated processing means. The testing device 30 simulates or emulates second IEDs 22 that are not physically present in the test environment according to an SCL description 23 of the substation (SCD) and IEDs (ICD).

Testing takes place by reading a test script or sequence 31 into a script interpreter 32, passing it to a plant simulator 33 to produce a simulated plant state 34. Based thereupon, the simulated second IEDs 22 generate network messages that are transmitted over the SA communication network 20 to the first IED 21 under test. The response of the latter is monitored by an analogue or binary signal analyser 35, and evaluated in comparator 36, together with network traffic generated by the IED 21 as well as information from the simulated plant state 34, to conclude whether or not the IED 21 operates as expected.

In detail, a test sequence thus starts with the testing device 30 loading the SCD and/or ICD files. Then the communication network 20 of the test environment where the IEDs Under Test (DUT) are installed is browsed for IEDs. This includes e.g. indicating an IP range (from 10.41.24.200 to 10.41.24.214) or a sub-network (10.41.24.XYZ), and sending out ping-commands. Those IEDs not responding must then be simulated. On the other hand, IEDs that appear on the communication network 20, but were not described fully or in part in the SCD file, can be integrated as real devices by the testing device 30.

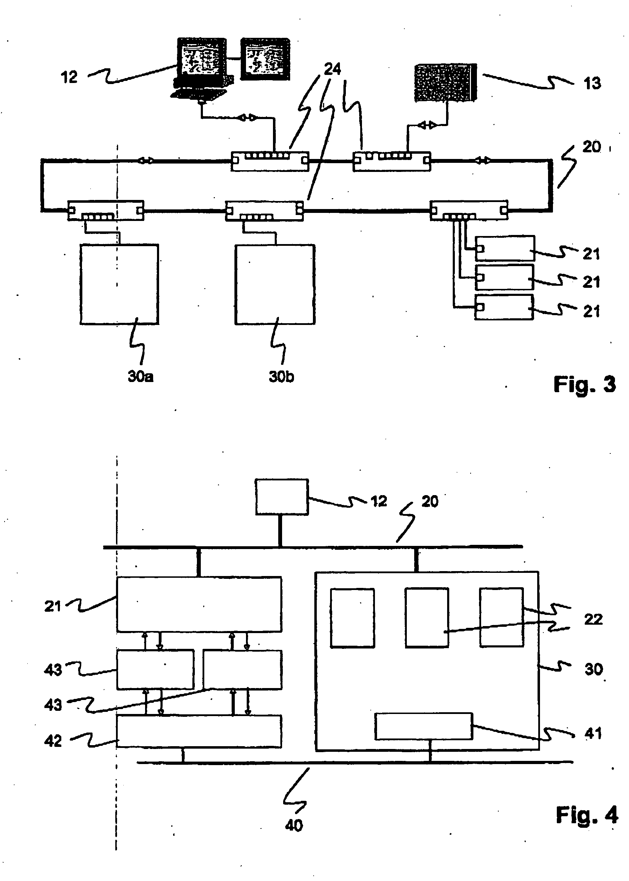

Fig.3 shows a test environment with two testing devices 30a, 30b, independently connected to the network 20 via dedicated Ethernet switches 24. An OWS 12, a communication gateway or telecontrol interface 13 as well as first IEDs 21 of a bay are likewise connected to the network 20 via their own switches 24.

Fig.4 shows a test environment with a testing device 30 simulating various IEDs 22, connected via communication network 30 to an IED under test 21. In addition, testing device 30 is connected, via remote control unit 41 and a tester network 40, to a remote controlled signal generator 42. The latter generates analogue signals representing current or voltage transformers, and binary signals representing sensors or status information, these simulated process signals are applied, using amplifiers 43 that are internal or external to the signal generator 42, to analogue and/or binary inputs of the IED 21 under test.

The only prerequisite for an IED type to be simulated is the availability of a model for the device type indicating how much network traffic it generates and receives under which circumstances. Accordingly, legacy devices and other non-state-of-the-art equipment, gateways, telecontrol links and logging devices are likewise amenable to simulation.

Ideally, the logic behind the simulated IEDs is reproduced as accurately as possible, i.e. information about primary devices is observed when preparing responses of the simulated IEDs. By way of example, switch-contact probes report "switch closed" only 30 ms after the command has been issued, hence this delay has to be reproduced by any realistic simulator as well. In addition, the same algorithms that are built into the real IEDs are preferably implemented in the simulator. Generally, the simulator must reproduce the behaviour of a substation with millisecond response, and has to be able to perform interlocking based on topography information. Furthermore, error situations must be simulated, such as a switch not opening or closing properly, simultaneous failures of primary and secondary devices, or bus bar short circuits with several tens of switches opening concurrently. The simulator must likewise be capable of realistically reproducing stress situations by sending e.g. 10'000 frames per second to the IEDs under test, and therefore needs appropriate processing power.

Preferably, the functional modules according to the invention are implemented as programmed software modules or procedures, respectively; however, one skilled in the art will understand that the functional modules can be implemented fully or partially in hardware. The computer program code of the programmed software modules is stored in a computer program product, e.g. in a computer readable medium, either in memory integrated in the testing device 30 or on a data carrier that can be inserted into the testing device 30.

### LIST OF DESIGNATIONS

- 10: bus bar
- 11: bay
- 12: Operator Work Station (OWS)
- 13: gateway
- 20: communication network
- 21: first Intelligent Electronic Device (IED)
- 22: second IED
- 23: SCD file
- 24: Ethernet switch
- 30: testing device
- 31: test script
- 32: script interpreter
- 33: plant simulator
- 34: simulated plant state
- 35: signal analyser
- 36: comparator
- 40: tester network
- 41: remote control unit
- 42: remote controlled signal generator
- 43: amplifier

## Claims

1. A method of performing a system level test of a first Intelligent Electronic Device (IED) (21) of a Substation Automation (SA) system, in which test a system level function of the SA system, involving the first IED (21) and a second IED (22), is tested based on network messages that are received by the first IED (21) over a communication network (20), the method comprising
- installing a fraction of a totality of IEDs of the SA system in a test environment,
- connecting a testing device (30) different from the second IED (22) to the communication network (20),
- detecting, by the testing device (30), the IEDs installed in the test environment,
- identifying IEDs of the SA system not installed in the test environment,
- reading, by the testing device (30), a standardized description of implemented device functions of the second IED (22),
- sending, by the testing device (30), network messages indicative of the behaviour of the second IED (22) in accordance with said system level function over the communication network (20) to the first IED (21),
- sending, by the testing device (30), network messages indicative of the behaviour of IEDs of the SA system not installed in the test environment, and
- monitoring a behaviour of the first IED (21) in response to said network messages.

2. The method according to claim 1, **characterized in that** it comprises
- providing an Operator Work Station (12) as the first IED under test.

3. The method according to claim 1, **characterized in that** it comprises
- running test sequences or scenarios by the testing device (30).

4. The method according to claim 3, **characterized in that** it comprises
- comparing the response of the first IED (21) with the test scenario.

5. A test environment for a Substation Automation (SA) system level test of a first Intelligent Electronic Device (IED) (21), in which test a system level function of a SA system involving the first IED (21) and a second IED (22) is tested based on network messages that are received by the first IED (21) over a communication network (20), the test environment comprising
- a fraction of a totality of IEDs of the SA system,
- a first testing device (30) different from the second IED (22), connected to the communication network, configured to read a standardized description of implemented device functions of the second IED (22) and configured to send network messages indicative of the behaviour of the second IED (22) in accordance with said system level function over the communication network (20) to the first IED (21), the first testing device (30) being further configured to detect IEDs installed in the test environment and to send network messages indicative of the behaviour of IEDs of the SA system not installed in the test environment,
- means for identifying IEDs of the SA system not installed in the test environment, and
- means for monitoring a behaviour of the first IED (21) in response to said network messages.

6. The test environment according to claim 5, **characterized in that** it comprises means for storing and executing (32) a test script (31).

7. The test environment according to claim 5, **characterized in that** the first IED to be tested is an Operator Work Station (12) of the SA system.

8. The test environment according to claim 5, **characterized in that** it comprises
- a second testing device (30b) connected to the communication network (20) independently from the first testing device (30a), and capable of sending network messages indicative of a behaviour of a third IED in accordance with said system level function.

9. The test environment according to claim 5, **characterized in that** it comprises a remote signal generator (42) controlled by the testing device (30) and provided for applying simulated process signals to the analogue and binary inputs of the first IED (21).

## Patentansprüche

1. Ein verfahren zum Durchführen einer Systemebenenprüfung einer ersten intelligenten elektronischen Einrichtung bzw. IED (21) eines Systems zur Schaltstation-Automatisierung bzw. SA, wobei bei dieser Prüfung eine Systemebenenfunktion des SA-Systems, woran die erste IED (21) und eine zweite IED (22) beteiligt sind, auf der Basis von Netzwerknachrichten, die die erste IED (21) über ein Kommunikationsnetzwerk (20) empfängt, geprüft wird, wobei das Verfahren Folgendes umfaßt:
- ein Teil einer Gesamtheit von IED des SA-Systems wird in einer Prüfumgebung installiert,
- eine Prüfeinrichtung (30), die von der zweiten IED (22) verschieden ist, wird mit dem Kommunikationsnetzwerk (20) verbunden,
- die Prüfeinrichtung (30) detektiert die in der Prüfumgebung installierten IED,
- IED des SA-Systems, die nicht in der Prüfumgebung installiert sind, werden identifiziert,
- die Prüfeinrichtung (30) liest eine standardisierte Beschreibung der implementierten Einrichtungsfunktionen der zweiten IED (22),
- die Prüfeinrichtung (30) sendet Netzwerknachrichten, die das Verhalten der zweiten IED (22) gemäß der Systemebenenfunktion angeben, über das Kommunikationsnetzwerk (20) zu der ersten IED (21),
- die Prüfeinrichtung (30) sendet Netzwerknachrichten, die das Verhalten der nicht in der Prüfumgebung installierten IED des SA-Systems angeben, und
- ein Verhalten der ersten IED (21) wird als Reaktion auf die Netzwerknachrichten überwacht.

2. Das Verfahren nach Anspruch 1, **dadurch gekennzeichnet, daß** es Folgendes umfaßt:
- als die erste geprüfte IED wird eine BedienerWorkstation (12) bereitgestellt.

3. Das Verfahren nach Anspruch 1, **dadurch gekennzeichnet, daß** es Folgendes umfaßt:
- die Prüfeinrichtung (30) läßt Prüfsequenzen oder -szenarien laufen.

4. Das Verfahren nach Anspruch 3, **dadurch gekennzeichnet, daß** es Folgendes umfaßt:
- die Antwort der ersten IED (21) wird mit dem Prüfszenario verglichen.

5. Eine Prüfumgebung für eine Prüfung einer ersten intelligenten elektronischen Einrichtung bzw. IED (21) auf der Ebene eines Systems zur Schaltstation-Automatisierung bzw. SA, wobei bei dieser Prüfung eine Systemebenenfunktion eines SA-Systems, woran die erste IED (21) und eine zweite IED (22) beteiligt sind, auf der Basis von Netzwerknachrichten, die die erste IED (21) über ein Kommunikationsnetzwerk (20) empfängt, geprüft wird, wobei die Prüfumgebung Folgendes umfaßt:
- ein Teil einer Gesamtheit von IED des SA-Systems,
- eine mit dem Kommunikationnetzwerk verbundene erste Prüfeinrichtung (30), die von der zweiten IED (22) verschieden ist, die zum Lesen einer standardisierten Beschreibung implementierter Einrichtungsfunktionen der zweiten IED (22) ausgelegt ist und die zum Senden von Netzwerknachrichten, die das Verhalten der zweiten IED (22) gemäß der Systemebenenfunktion angeben, über das Kommunikationsnetzwerk (20) zu der ersten IED (21) ausgelegt ist, wobei die erste Prüfeinrichtung (30) weiter zum Detektieren von in der Prüfumgebung installierten IED und zum Senden von Netzwerknachrichten, die das Verhalten der nicht in der Prüfumgebung installierten IED des SA-Systems angeben, ausgelegt ist,
- Mittel zum Identifizieren von IED des SA-Systems, die nicht in der Prüfumgebung installiert sind, und
- Mittel zum Überwachen eines Verhaltens der ersten IED (21) als Reaktion auf die Netzwerknachrichten.

6. Die Prüfumgebung nach Anspruch 5, **dadurch gekennzeichnet, daß** sie Mittel zum Speichern und Ausführen (32) eines Prüfskripts (31) umfaßt.

7. Die Prüfumgebung nach Anspruch 5, **dadurch gekennzeichnet, daß** die erste zu prüfende IED eine Bediener-Workstation (12) des SA-Systems ist.

8. Die Prüfumgebung nach Anspruch 5, **dadurch gekennzeichnet, daß** sie Folgendes umfaßt:
- eine unabhängig von der ersten Prüfeinrichtung (30a) mit dem Kommunikationsnetzwerk (20) verbundene zweite Prüfeinrichtung (30b) mit der Fähigkeit zum Senden von Netzwerknachrichten, die das Verhalten einer dritten IED gemäß der Systemebenenfunktion angeben.

9. Die Prüfumgebung nach Anspruch 5, **dadurch gekennzeichnet, daß** sie einen von der Prüfeinrichtung (30) gesteuerten Fernsignalgenerator (42) umfaßt, der dafür vorgesehen ist, simulierte Prozeßsignale an die analogen und binären Eingänge der ersten IED (21) anzulegen.

## Revendications

1. Un procédé de mise en oeuvre d'un test au niveau système d'un premier dispositif électronique intelligent (IED) (21) d'un système d'automatisation de sous-stations (SA), test dans lequel une fonction au niveau système du système SA mettant en jeu le premier IED (21) et un deuxième IED (22) est testée à partir de messages de réseau reçus par le premier IED (21) via un réseau de communication (20), le procédé comprenant les étapes consistant à :
- installer une partie d'une totalité des IED du système SA dans un environnement de test,
- connecter un dispositif de test (30) différent du deuxième IED (22) au réseau de communication (20),
- détecter, au moyen du dispositif de test (30), les IED installés dans l'environnement de test,
- identifier des IED du système SA non installés dans l'environnement de test,
- lire, au moyen du dispositif de test (30), une description normalisée de fonctions de dispositif implémentées du deuxième IED (22),
- envoyer au premier IED (21), au moyen du dispositif de test (30), des messages de réseau reflétant le comportement du deuxième IED (22) conformément à ladite fonction au niveau système via le réseau de communication (20),
- envoyer, au moyen du dispositif de test (30), des messages de réseau reflétant le comportement des IED du système SA non installés dans l'environnement de test, et
- surveiller un comportement du premier IED (21) en réponse auxdits messages de réseau.

2. Le procédé selon la revendication 1, **caractérisé en ce qu'**il comprend l'étape consistant à :
- utiliser en tant que premier IED testé un poste de travail d'opérateur (12).

3. Le procédé selon la revendication 1, **caractérisé en ce qu'**il comprend l'étape consistant à :
- lancer des séquences ou scénarios de test au moyen du dispositif de test (30).

4. Le procédé selon la revendication 3, **caractérisé en ce qu'**il comprend l'étape consistant à :
- comparer la réponse du premier IED (21) au scénario de test.

5. Un environnement de test pour un test au niveau système d'automatisation de sous-stations (SA) d'un premier dispositif électronique intelligent (IED) (21), test dans lequel une fonction au niveau système d'un système SA mettant en jeu le premier IED (21) et un deuxième IED (22) est testée à partir de messages de réseau reçus par le premier IED (21) via un réseau de communication (20), l'environnement de test comprenant :
- une partie d'une totalité des IED du système SA,
- un premier dispositif de test (30) différent du deuxième IED (22), connecté au réseau de communication, configuré pour lire une description normalisée de fonctions de dispositif implémentées du deuxième IED (22) et configuré pour envoyer au premier IED (21) des messages de réseau reflétant le comportement du deuxième IED (22) conformément à ladite fonction au niveau système via le réseau de communication (20), le premier dispositif de test (30) étant en outre configuré pour détecter des IED installés dans l'environnement de test et pour envoyer des messages de réseau reflétant le comportement des IED du système SA non installés dans l'environnement de test,
- des moyens pour identifier des IED du système SA non installés dans l'environnement de test, et
- des moyens pour surveiller un comportement du premier IED (21) en réponse auxdits messages de réseau.

6. L'environnement de test selon la revendication 5, **caractérisé en ce qu'**il comprend un moyen destiné à stocker et à exécuter (32) un script de test (31).

7. L'environnement de test selon la revendication 6, **caractérisé en ce que** le premier IED à tester est un poste de travail d'opérateur (12) du système SA.

8. L'environnement de test selon la revendication 6, **caractérisé en ce qu'**il comprend :
- un deuxième dispositif de test (30b) connecté au réseau de communication (20) indépendamment du premier dispositif de test (30a), et capable d'envoyer des messages de réseau reflétant un comportement d'un troisième IED conformément à ladite fonction au niveau système.

9. L'environnement de test selon la revendication 6, **caractérisé en ce qu'**il comprend un générateur (42) de signaux à distance commandé par le dispositif de test (30) et utilisé pour appliquer des signaux de processus simulés aux entrées analogiques et binaires du premier IED (21).
